Europäisches Patentamt

European Patent Office

Office européen des brevets

(11) Numéro de publication: **0 320 341 B1**

# FASCICULE DE BREVET EUROPEEN

(45) Date de publication de fascicule du brevet: **14.04.93** (51) Int. Cl.⁵: **G01R 15/02**, H01F 40/06

(21) Numéro de dépôt: **88403032.1**

(22) Date de dépôt: **01.12.88**

(54) Appareil de mesure de courants électriques à couplage magnétique.

(30) Priorité: **11.12.87 FR 8717313**

(43) Date de publication de la demande:
**14.06.89 Bulletin 89/24**

(45) Mention de la délivrance du brevet:
**14.04.93 Bulletin 93/15**

(84) Etats contractants désignés:
**DE GB IT**

(56) Documents cités:
**EP-A- 0 194 225**

(73) Titulaire: **AGENCE SPATIALE EUROPEENNE**
**8-10, rue Mario Nikis**
**F-75738 Paris Cedex 15(FR)**

(72) Inventeur: **Ghislanzoni, Luca**
**Dobbelmanduin 2**
**Noordwijk(NL)**

(74) Mandataire: **Ores, Irène et al**
**CABINET ORES 6, Avenue de Messine**
**F-75008 Paris (FR)**

## Description

La présente invention est relative à un appareil de mesure de courants électriques alternatifs et/ou continus, du type à couplage magnétique.

La mesure de courants électriques utilise des dispositifs dits "galvano-magnétiques" comme éléments de détection. (Des renseignemnts détaillés sur ces dispositifs existent dans la littérature technique et l'on peut utile-ment consulter la publication SIEMENS"Galvanomagnetic Devices"Data Book 1976/77). Cette mesure est effectuée selon deux techniques différentes.

La première technique est une technique dans laquelle, théoriquement au moins, on ne devrait effectuer aucune compensation des variations de flux magnétique. L'appareil de mise en oeuvre correspondant comprend essentiellement un circuit magnétique comportant un entrefer dans lequel est inséré le dispositif "galvano-magnétique" Le circuit magnétique est excité par le courant circulant dans un enroulement. Les variations de flux correspondent aux variations du courant d'entrée selon l'équation :

$$(1) \quad \left| \frac{dB^*}{dt} \right| = \frac{L}{NA_s} \cdot \left| \frac{di}{dt} \right| = \frac{L}{NA_s} \quad \omega \quad |i|$$

où :
- $B^*$ est la valeur de l'induction magnétique,
- i, le courant d'entrée de fréquence $f = \frac{\omega}{2\pi}$ $\omega$ étant la pulsation,
- N, le nombre de spires de l'enroulement,
- $A_s$, la surface du circuit magnétique entouré par cet enroulement,
- L, l'inductance tenant compte de l'effet du circuit magnétique.

Etant donné que les câbles électriques de connexion associés au dispositif "galvano-magnétique" constituent une boucle dont la surface ne peut pas être annulée complètement et que donc la surface de cette boucle - bien que faible - présente une valeur finie A différente de zéro, la tension électrique $v_i^*$ induite entre les bornes de sortie est définie par l'expression suivante, qui est valable dans l'hypothèse que les fuites magnétiques (et donc l'inductance de fuite) ainsi que l'augmentation de la surface de l'entrefer effectif soient négligeables :

$$(2) \quad v_i^* = - A \frac{dB^*}{dt}$$

Dans les mêmes hypothèses on peut exprimer la tension $v_i^*$ comme une fraction de la tension $v_s$ induite dans l'enroulement précité, à savoir :

$$(3) \quad v_i^* = \frac{v_s}{N} \frac{A}{A_s} \cdot$$

En outre, si l'on exprime de façon classique l'inductance L comme le produit du nombre de spires au carré $N^2$ par une constante K, $L = KN^2$, on peut également exprimer $v_i^*$ qui figure dans l'équation (2) de la manière suivante, en tenant compte de l'équation (1) :

$$(4) \quad \left| v_i^* \right| = |i| \cdot \omega \cdot K \cdot \frac{A}{A_s} \cdot N \cdot$$

L'équation (4) montre que la tension électrique induite est directement proportionnelle au nombre de spires N et à la pulsation $\omega$.

Cela signifie que la valeur de $v_i^*$ est telle que le plus souvent s'impose,en pratique,une compensation (selon des techniques connues des techniciens en la matière) qui contribue à compliquer encore plus la conception du circuit de mesure.

Les appareils de cette catégorie présentent donc l'inconvénient de requérir une valeur d'inductance très élevée (à savoir, un nombre élevé de spires), qui est nécessaire pour obtenir la sensibilité désirée du

2

dispositif de mesure : cette condition se traduit dans une valeur relativement élevée de la tension induite entre les bornes du dispositif et correspond à un comportement qui est loin d'être idéal.

La deuxième technique de mesure de courants électriques, à l'aide de dispositifs "galvano-magnétiques", est une technique dans laquelle on effectue une compensation active des variations de flux magnétique.

L'appareil de mise en oeuvre correspondant diffère, par rapport à celui utilisé dans le cadre de la première technique précitée, en ce que le circuit magnétique comporte un enroulement auxiliaire en plus de l'enroulement principal d'excitation. Un circuit de contreréaction amène le courant dans cet enroulement auxiliaire de manière à obtenir une compensation totale des variations de flux magnétique , à savoir une valeur nulle ou constante de l'induction magnétique B.

Le circuit de contreréaction doit être conçu de manière à présenter une largeur de bande qui s'étend de la fréquence nulle (correspondant au régime en courant continu) à la fréquence désirée (en régime de courant alternatif).

De toutes façons, la variation de flux est très faible (théoriquement nulle), en sorte que la compensation de la tension induite est pratiquement efficace.

De plus, l'impédance du dispositif de mesure est elle aussi très faible (théoriquement nulle).

Toutefois, bien qu'un appareil de mise en oeuvre de la deuxième technique présente un comportement très voisin du comportement idéal, la réalisation du circuit de contreréaction évoqué plus haut est relativement complexe (en raison de la largeur de bande étendue qu'il faut assurer); en outre, une valeur de courant élevé requiert un enroulement auxiliaire de compensation comportant un nombre de spires élevé pour réduire le courant de compensation et donc la puissance nécessaire.

Le champ d'application de cette deuxième catégorie d'appareils de mesure est donc limité par les contraintes précitées.

La présente invention s'est donc donné pour but de pourvoir à un appareil de mesure de courant à couplage magnétique qui répond mieux aux nécessités de la pratique que les appareils visant au même but antérieurement connus, notamment en ce que :

- aucune compensation des variations de flux magnétique n'est nécessaire, sans pour autant utiliser les circuits de compensation par contreréaction très complexes de l'art antérieur,
- ses performances s'approchent de celles d'un appareil de mesure de courant idéal (dont la propriété est d'avoir une impédance nulle), parce que son impédance est extrêmement faible, ce qui élimine l'inconvénient qui limitait, dans l'art antérieur, l'utilisation des appareils de mesure de courant à couplage magnétique et qui était dû à la valeur élevée de leur impédance,
- les pertes dans le fer sont réduites drastiquement, ce qui élimine l'inconvénient constitué par le choix limité des matériaux pour le circuit magnétique.

L'appareil objet de la présente invention définit une troisième technique de mesure, qui peut être qualifiée de compensation "passive" (ou intrinsèque)des variations de flux magnétique et qui, tout en permettant de maintenir les avantages des appareils de la deuxième catégorie, autorise la réalisation d'appareils (appartenant donc à une troisième catégorie) dont la conception et la structure sont beaucoup plus simples.

De plus, il faut souligner que la contreréaction qu'ils permettent d'introduire de façon intrinsèque (c'est-à-dire qu'elle est propre à leur structure), est beaucoup plus efficace (surtout aux fréquences élevées) que celle qui peut être obtenue par n'importe quel type de circuit de contrereaction actif.

La présente invention a pour objet un appareil de mesure de courant, du type à couplage magnétique, comportant :

- un transformateur comprenant un circuit magnétique formé par un noyau en matériau ferromagnétique avec un entrefer, un enroulement primaire disposé autour du noyau et parcouru par le courant à mesurer, et un enroulement secondaire disposé autour du noyau,
- des moyens destinés à fournir à partir du flux magnétique induit par le courant dans le noyau, un premier signal électrique proportionnel à la somme des composantes alternatives à fréquences élevées du courant à mesurer,
- un dispositif placé dans l'entrefer du noyau et destiné à fournir, à partir du flux magnétique induit par le courant dans le noyau et traversant l'entrefer, un second signal électrique proportionnel à la somme des composantes continue et alternatives à basses fréquences du courant à mesurer,
- et un moyen de sommation desdits premier et second signaux pour fournir un troisième signal proportionnel au courant à mesurer.

Selon un mode de réalisation préféré de l'appareil conforme à l'Invention, lesdits moyens pour fournir ledit premier signal sont constitués par l'enroulement secondaire qui est sensiblement courtcircuité par une impédance de très faible valeur, ledit premier signal étant prélevé aux bornes de l'impédance qui peut être avantageusement constituée par une résistance pure.

Selon un autre mode de réalisation de l'appareil conforme à l'Invention, lesdits moyens pour fournir ledit premier signal sont constitués par un amplificateur, qui est alimenté par ledit enroulement secondaire et dont l'entrée et la sortie présentent une borne commune, ledit premier signal étant défini par la tension existant entre les bornes d'une impédance d'accès et à la sortie de l'amplificateur équivalente à l'admittance de la liaison entre entrée et sortie dudit amplificateur.

Selon encore un mode de réalisation de l'appareil conforme à l'Invention, lesdits moyens pour fournir ledit premier signal sont constitués par un troisième enroulement disposé autour dudit circuit magnétique, ledit premier signal étant défini par la tension existant entre les bornes dudit troisième enroulement, et en ce que ledit troisième enroulement comporte un nombre de spires très élevé.

Selon un mode de réalisation avantageux de l'appareil conforme à l'invention, ledit moyen de sommation desdits premier et deuxième signaux est constitué par un amplificateur opérationnel à bande passante large qui reçoit à ses bornes d'entrée une des bornes de sortie desdits moyens fournissant lesdits premier et deuxième signaux, les autres bornes de ces derniers étant communes.

Selon un autre mode de réalisation avantageux de l'appareil conforme à l'invention, un amplificateur à bande passante étendue amplifie ledit premier signal, tandis qu'un amplificateur à bande passante moyenne amplifie ledit deuxième signal.

Outre les dispositions qui précèdent, l'invention comprend encore d'autres dispositions, qui ressortiront de la description qui va suivre.

L'invention sera mieux comprise à l'aide du complément de description qui va suivre, qui se réfère aux dessins annexés dans lesquels :

- la figure 1 représente un premier mode de la solution de principe selon laquelle est réalisé l'appareil de mesure conforme à l'invention ;
- les figures 2 et 3 représentent deux configurations possibles du circuit de la figure 1,lorsqu'on dispose un générateur à effet Hall dans l'entrefer du transformateur ;
- la figure 2A représente en détail une possible structure du circuit de la figure 2 ;
- la figure 4 illustre le schéma équivalent du transformateur représenté aux figures 1 à 3 ;
- la figure 5 est une variante de réalisation de l'appareil illustré à la figure 1 ;
- la figure 6 est une configuration équivalente à la configuration illustrée à la figure 1 ;
- la figure 7 est une autre variante de réalisation par rapport à l'appareil de la figure 1.

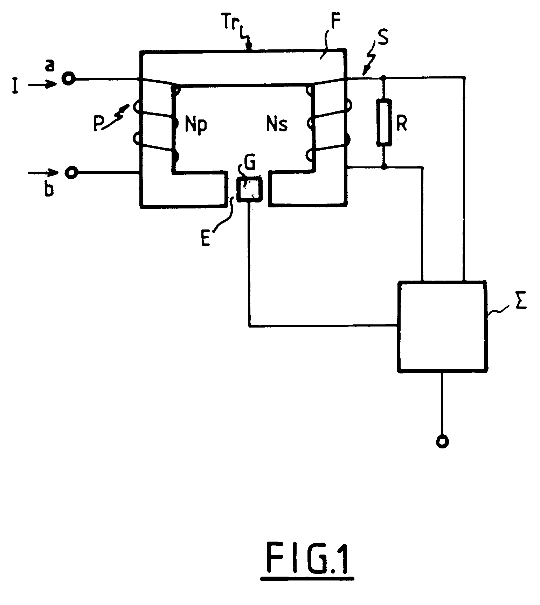

La figure 1 est une illustration schématique de l'appareil de mesure de courant selon l'invention.

$T_r$ est un transformateur, dont le circuit magnétique F présente un entrefer E.

R est une résistance de très faible valeur, notamment de l'ordre de 10 m$\Omega$.

G est un dispositif "galvano-magnétique" (tel qu'un générateur à effet Hall ou n'importe quel autre dispositif fournissant entre ses bornes de sortie un signal qui est fonction du flux magnétique), qui est placé dans l'entrefer.

$\Sigma$ est un circuit sommateur (passif ou actif) dont la sortie est fonction du courant d'entrée I à mesurer circulant dans l'enroulement primaire P constitué d'un nombre de spires $N_p$, $N_s$ étant le nombre de spires du circuit secondaire S.

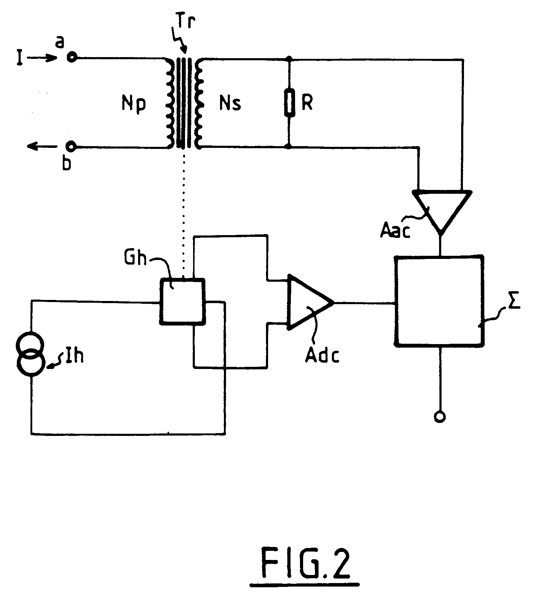

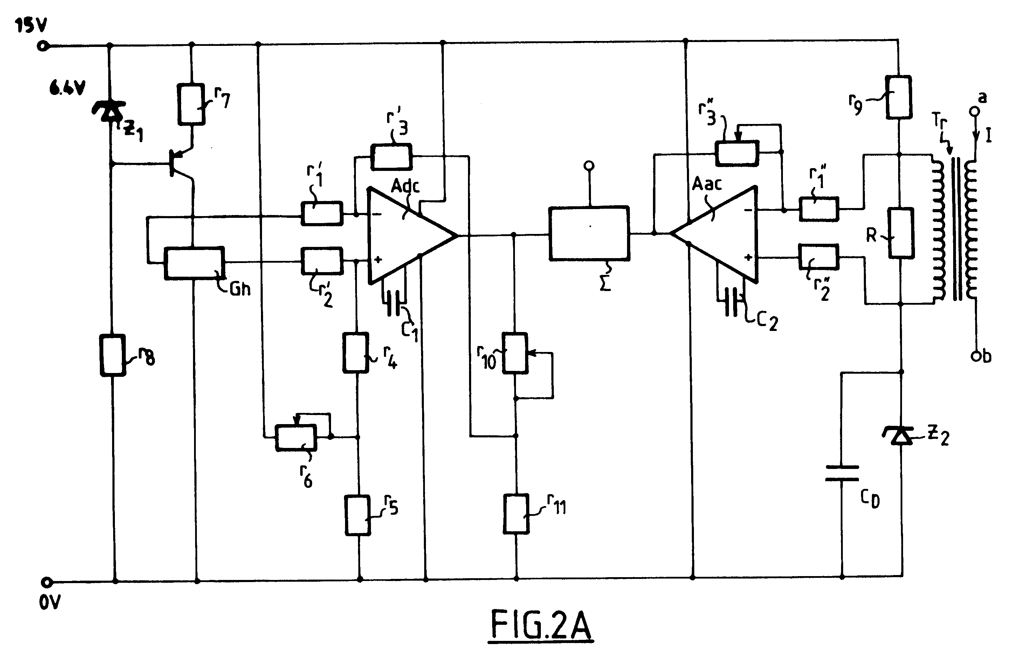

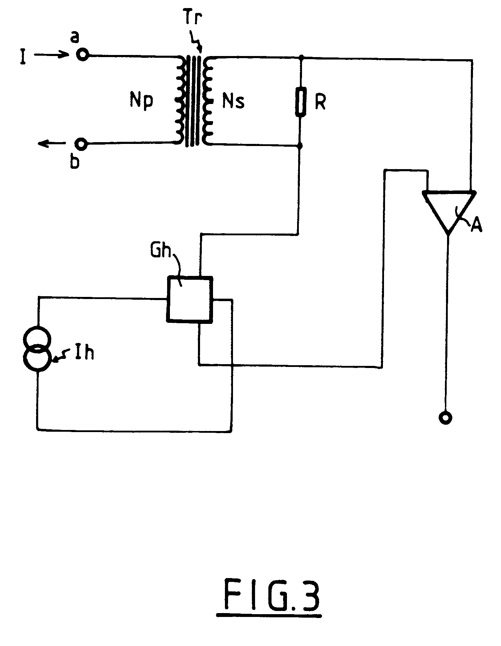

Aux figures 2 et 3 sont illustrées deux configurations possibles du dispositif de la figure 1 utilisant, par exemple, un générateur à effet Hall $G_h$, dont l'interaction avec le champ magnétique du transformateur est représentée schématiquement par une ligne en pointillé. $I_h$ est la source de courant alimentant $G_h$.

Dans la figure 3, A est un amplificateur à bande passante étendue.

Dans la figure 2, $A_{dc}$ est un amplificateur à bande passante moyenne et à gain élevé dont l'entrée est définie par la tension due à l'effet Hall et disponible entre ses bornes de sortie, tandis que $A_{ac}$ est un amplificateur à bande passante étendue et à gain moyen, qui est sensible à la tension alternative à la fréquence élevée qui existe entre les bornes de la résistance R.

La figure 2A montre en détail une configuration possible du circuit illustré à la figure 2, dans laquelle on retrouve le transformateur $T_r$, le dispositif $G_h$, les amplificateurs $A_{dc}$ et $A_{ac}$ (qui sont du type désigné par la référence LM 308) ainsi que la résistance R insérée entre les bornes de l'enroulement secondaire. On suppose que, dans le circuit de figure 2A la résistance R a la valeur de 50 m$\Omega$ et que les autres éléments du circuit ont les valeurs indiquées ci-après :

$r'_1 = r'_2 = r'_3 = 10$ k$\Omega$
$r''_1 = r''_2 = r_5 = r_7 = 1$ k$\Omega$
$r''_3 = 200$ k$\Omega$
$r_4 = r_8 = r_9 = 8$ k$\Omega$
$r_6 = r_{10} = 100$ k$\Omega$

$r_{11}$ = 470 $\Omega$

$C_1$ = $C_2$ = 3,3 pF.

Dans le circuit de figure 2A on voit aussi un transistor PNP du type 2 N 2907 A et deux diodes Zener $Z_1$, $Z_2$.

$C_D$ est la capacité découplée d'un condensateur de découplage de la capacité existant entre les enroulements primaires et secondaires.

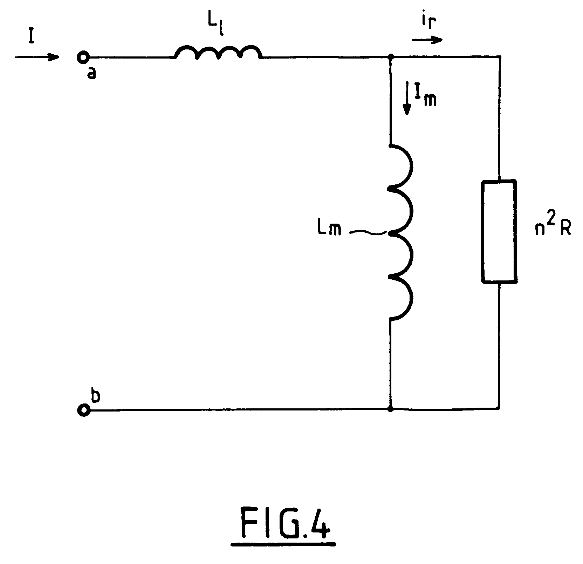

La figure 4 illustre le circuit équivalent du dispositif de mesure des figures 1 à 3.

Dans ce circuit équivalent,$L_1$ est l'inductance de fuite, $L_m$ l'inductance qui tient compte de l'effet du circuit magnétique et $n^2R$ est la résistance équivalente à la résistance R insérée dans le circuit secondaire du transformateur et rapportée au circuit primaire, avec

$$n = \frac{N_p}{N_s} .$$

Le courant d'entrée I comporte en général une composante continue $I_{dc}$ et une composante alternative i ( $\omega$ ), où $\omega$ = $2\pi f$ . Lorsque la composante $I_{dc}$ est présente, celle-ci circule nécessairement à travers $L_m$ dans le circuit équivalent précité, étant donné que la branche $n^2R$ de ce circuit tient essentiellement compte de l'effet "transformateur".

Si l'on indique avec $i_m(\omega)$ et $i_r(\omega)$ les courants alternatifs correspondant au courant $i(\omega)$ et circulant à travers $L_m$ et $n^2R$, respectivement, il est clair que $i(\omega)$ = $i_m(\omega)$ + $i_r(\omega)$ et que, en général, le courant $I_m$ qui traverse $L_m$ est donné par $I_m$ = $I_{dc}$ + $i_m$, tandis que $n^2R$ est traversé essentiellement par $i_r$. Le courant I est donc :

(5)    I = $I_m$ + $i_r$ .

Le courant $I_m$ est fonction du flux magnétique et est détecté par le dispositif G sous forme d'un signal de tension $v_i$, tandis que le courant $i_r$ peut être détecté par l'intermédiaire de la tension $v_r$ induite dans l'enroulement secondaire S, à laquelle $i_r$ est liée par l'équation :

(6)    $v_r$ = $i_r$ . $n^2R$.

Or, il est facile d'exprimer les courants $i_r$ ($\omega$) et $i_m(\omega)$ en fonction du courant $i(\omega)$, selon les expressions suivantes :

$$(7) \qquad \left| i_r(\omega) \right| = \left| i(\omega) \right| \frac{\omega L_m}{\sqrt{n^4 R^2 + \omega^2 L_m^2}}$$

$$(8) \qquad \left| i_m(\omega) \right| = \left| i(\omega) \right| \frac{n^2 R}{\sqrt{n^4 R^2 + \omega^2 L_m^2}}$$

Ces expressions montrent clairement que, lorsque

$$\omega \gg \frac{n^2 R}{L_m}$$

il résulte que :

$$\left| i_r(\omega) \right| \cong \left| i(\omega) \right| ,$$

tandis que, lorsque

5

$$\omega \ll \frac{n^2 R}{L_m} \quad ,$$

il résulte que :

$$|i_m(\omega)| \cong |i(\omega)| \ ,$$

ce qui signifie que l'amplificateur $A_{dc}$ ne nécessite pas une grande largeur de bande (jusqu'à $1kH_z$ c'est pratiquement suffisant), la largeur de bande totale étant définie par la bande passante de l'amplificateur $A_{ac}$.

Ce qui précède montre clairement que, comme résultat du fait que l'enroulement secondaire est pratiquement court-circuité, le courant alternatif $i_r$ qui le traverse comporte des composantes de fréquences élevées.

Au contraire, le courant alternatif $i_m$, qui tient compte de l'effet du circuit magnétique, comporte des composantes de basses fréquences ainsi que l'éventuelle composante continue, ce qui se traduit par des variations très faibles du flux dans le circuit magnétique et justifie le fait que le dispositif selon l'invention ne nécessite aucune compensation des variations de flux.

L'équation 5 montre donc qu'en fermant l'enroulement secondaire pratiquement en court-circuit (vu la valeur très faible de la résistance R) on a pu obtenir la séparation, d'une part, des composantes continue et alternatives à basses fréquences, représentées par $I_m$, et d'autre part, des composantes alternatives à fréquences élevées, représentées par $i_r$.

Etant donné que le signal $v_i$ fourni par le dispositif G est proportionnel à l'induction magnétique, il s'ensuit que ce signal et cette induction correspondent à la composante continue et aux composantes à basses fréquences, tandis que le signal $v_r$, disponible aux bornes de la résistance R, est proportionnel aux composantes à fréquences élevées.

Donc, la somme de ces deux signaux $v_i$ et $v_r$ est la reproduction fidèle du courant d'entrée I objet de la mesure.

Dans les mêmes conditions évoquées plus haut, il est également facile de vérifier que l'impédance de l'appareil de mesure, entre les bornes d'entrée $\underline{a}$ et $\underline{b}$ est donnée par :

$$(9) \qquad |Z_{ab}| \quad \cong \quad \sqrt{n^4 R^2 + \omega^2 L_1^2} \quad , \ \text{pour} \quad \omega \gg \frac{n^2 R}{L_m}$$

et

$$(10) \qquad |Z_{ab}| \quad \cong \quad \omega \cdot (L_m + L_1) \ , \quad \text{pour} \quad \omega \ll \frac{n^2 R}{L_m} \ ,$$

l'expression (9) représentant aussi la valeur maximale de l'impédance, $|Z_{ab}|_{maxi}$ ,qui, lorsque l'inductance de fuite $L_1$ est négligeable, est égale à $n^2 R$.

En admettant que le courant d'entrée soit défini par un courant sinusoïdal i et que $L_1 \cong 0$, la tension $v_i$ induite aux bornes du dispositif $G_h$ peut être exprimée en fonction de la tension $v_{ab}$ entre les bornes d'entrée :

$$(11) \qquad |v_i| \quad = \quad \left|\frac{v_{ab}}{N_p}\right| \cdot \frac{A}{A_s}$$

Si l'on exprime $v_{ab}$ comme produit de $i_r$ par $n^2 R$, il est aussi possible d'écrire :

$$(12) \qquad |v_i| \quad = \quad \frac{1}{N_p} \cdot \frac{A}{A_s} \cdot |i| \frac{n^3 R \omega L_m}{\sqrt{n^4 R^2 + \omega^2 L_m^2}}$$

A partir de l'équation (12) il est facile de déterminer la valeur maximale $V_{i,maxi}$ de $|v_i|$ que celle-ci présente aux hautes fréquences :

$$(12bis) \quad V_{i,maxi} = \frac{1}{N_p} \cdot \frac{A}{A_s} \cdot |i| \ n^2R \ \gg \ |v_i| \cdot$$

L'équation (12bis) montre que cette valeur maximale est indépendante de la fréquence et qu'elle est inversement proportionnelle au nombre de spires $N_p$ de l'enroulement primaire, et ce contrairement à la dépendance définie par l'équation (4) précitée, qui a été établie dans le cadre de la première méthode de mesure de l'art antérieur.

Si l'on effectue le rapport entre les équations (4) et (12bis), l'on a, à conditions égales en ce qui concerne les grandeurs homologues qui y figurent :

$$(13) \quad \frac{|v_i^*|}{V_{i,maxi}} = \frac{\omega KN^2}{n^2R} = \frac{\omega L_m}{n^2R}$$

où $L_m = KN^2$ représente l'inductance qui tient compte de l'effet du circuit magnétique, supposée elle aussi égale dans les deux cas.

En admettant que :

$L_m = 100 \ \mu H$

$R = 10 \ m\Omega$

$n = 1$

$f = 100 \ kH_z$

l'équation (13) donne un rapport

$$\frac{|v_i^*|}{V_{i,maxi}} \cong 6,3 \ . \ 10^3$$

ce qui montre que l'on peut mesurer, à l'aide de l'appareil selon l'invention, une tension sensiblement inférieure par rapport à l'appareil permettant la mise en oeuvre de la première méthode de l'art antérieur évoquée plus haut, et ce seulement en ajoutant dans le circuit magnétique un enroulement secondaire fermé sur une charge constituée par une résistance (en général, par une impédance) de très faible valeur.

En outre, si l'on considère la variation de l'induction magnétique, par analogie avec l'équation (1) précitée, on peut exprimer cette variation dans le cas de l'appareil conforme à l'invention comme suit :

$$(14) \quad \left|\frac{dB}{dt}\right| = \frac{L_m \ \omega \ |i_m|}{N_p \ A_s} = \frac{\omega L_m}{N_p \ A_s} \ \frac{|i| \ n^2R}{\sqrt{n^4R^2 + \omega^2 L_m^2}}$$

Egalement dans ce cas, on peut calculer la valeur maximale de cette variation d'induction magnétique, que celle-ci présente aux hautes fréquences :

$$(14bis) \quad \left|\frac{dB}{dt}\right|_{maxi} = \frac{\omega L_m}{N_p \ A_s} \cdot \frac{|i| \ n^2R}{\omega L_m} = \frac{n^2R \ |i|}{N_p \ A_s} \gg \left|\frac{dB}{dt}\right|$$

Le rapport entre les équations (1) et (14bis), effectué en admettant égales toutes les grandeurs homologues qui y figurent, donne :

$$(15) \quad \left|dB^*/dt\right| \Big/ \left|dB/dt\right| \ \gg \ \frac{\omega L_m}{n^2R} \ ,$$

cette équation étant évidemment en accord avec l'équation (13).

Or, étant donné que les pertes magnétiques sont approximativement proportionnelles à $|dB/dt|^2$ (plus exactement, elles sont proportionnnelles à $\omega^\alpha$ $B^\beta$, $\alpha$ et $\beta$ étant des coefficients appropriés fonction de la fréquence), il est donc clair que l'appareil selon l'invention permet de réduire d'un facteur sensiblement égal à $10^7$ les pertes magnétiques par rapport aux pertes qui ont lieu dans un **appareil de mise en oeuvre** de la première méthode de l'art antérieur.

Cela a comme conséquence inattendue que l'on n'a plus besoin de réaliser le circuit magnétique en ferrite - qui est un matériau très fragile et dont la mise en forme est difficile - ni de le laminer.

Pour un prototype réalisé en fer doux non laminé, avec R = 50 mΩ , $L_m$ = 80 μH, un courant d'entrée sinusoïdal présentant un écartement de 1A entre les valeurs maximales positive et négative et une fréquence f = 100 kHz, l'on a pu évaluer à 40 mW les pertes totales dans le fer et dans le cuivre, 6,5 mW ayant été dissipés dans la résistance R.

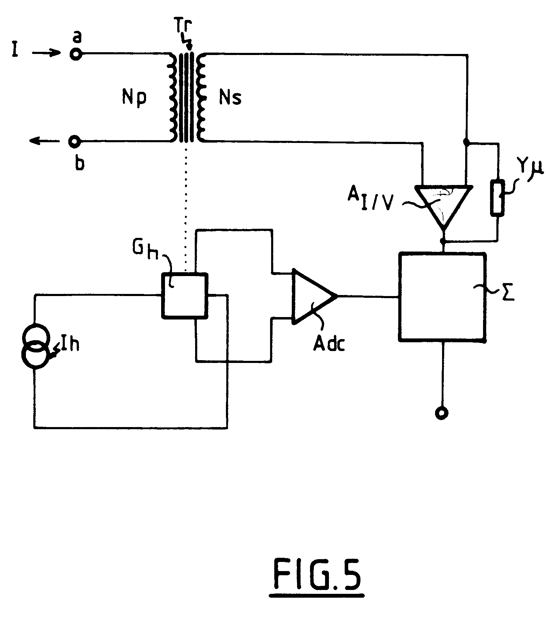

Les valeurs calculées à partir des équations (12)-(12bis) et (14)-(14bis) peuvent être réduites encore plus à l'aide d'un amplificateur $A_{I/V}$ (cf. la figure 5), qui est alimenté par l'enroulement secondaire S et dont l'entrée et la sortie présentent une borne commune. En fait, si l'on indique avec $Y_\mu$ l'admittance, très élevée (théoriquement infinie), de la liaison entre l'entrée et la sortie de l'amplificateur $A_{I/V}$, l'application du théorème de MILLER permet d'affirmer que, dans le cas où le gain de cet amplificateur est nettement supérieur à l'unité, l'admittance précitée se retrouve telle quelle à la sortie et multipliée par le gain (changé de signe) à l'entrée. Cela signifie qu'en réalité l'amplificateur **présente une impédance d'entrée et de sortie** $Z_\mu$ = $1/Y_\mu$ qui est très basse (théoriquement nulle), comme exigé par le fonctionnement de l'appareil de mesure selon l'invention.

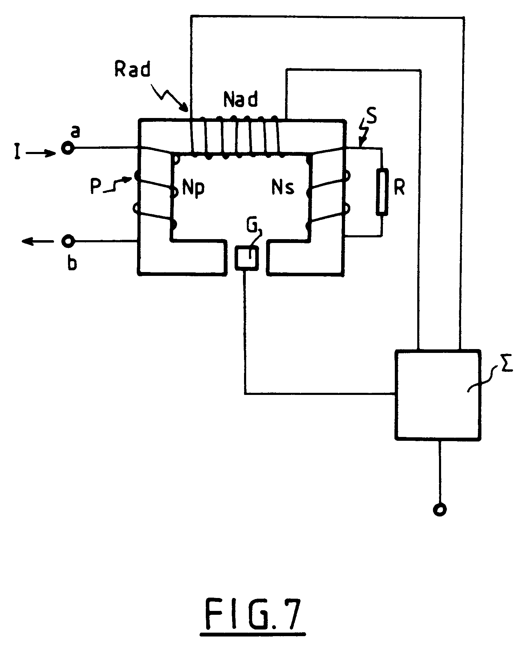

Les performances de l'appareil de mesure peuvent être encore améliorées en adoptant la configuration illustrée à la figure 7, à savoir en utilisant un troisième enroulement $R_{ad}$ comportant un nombre de spires $N_{ad}$ très élevé et en utilisant la tension $v_{ad}$ disponible entre les bornes de l'enroulement $R_{ad}$ comme signal proportionnel à la somme des composantes alternatives à fréquences élevées (représentées par le terme $i_r$ indiqué plus haut) du courant I à mesurer.

En effet, dans l'hypothèse - déjà évoquée précédemment - où l'inductance de fuite $L_1$ est négligeable, on peut exprimer la tension $v_{ab}$ entre les bornes d'entrée de l'appareil comme étant égale pratiquement à $n^2 R$ $i_r$.

La valeur de $v_{ad}$ peut donc être calculée à partir de la proportion suivante :

$$\frac{v_{ab}}{v_{ad}} = \frac{N_p}{N_{ad}}$$

ce qui permet d'écrire que :

$$v_{ad} = n^2 R\ i_r\ \frac{N_{ad}}{N_p}\ .$$

Le nombre de spires $N_{ad}$ peut être rendu aussi élevé que possible - les seules limites étant essentiellement d'ordre pratique et notamment liées aux problèmes de coût et d'encombrement - étant donné que cet enroulement additionnel n'est pas traversé par du courant et ne met donc en jeu aucune puissance électrique.

La solution de la figure 7 permet de réduire la valeur de résistance R insérée dans l'enroulement secondaire jusqu'à l'annuler pour n'avoir que la résistance de l'enroulement secondaire S correspondant.

En outre, le fait d'avoir entre les bornes de l'enroulement additionnel $R_{ad}$ une tension de valeur relativement élevée permet d'augmenter la largeur de la bande passante (pratiquement, jusqu'à l'infini, si aucune amplification n'est nécessaire).

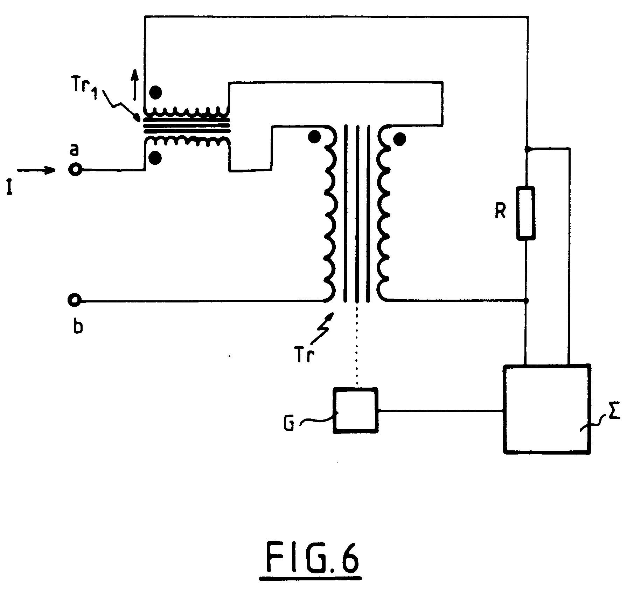

La configuration du circuit de figure 1 peut être généralisée selon ce qui est illustré à la figure 6, qui montre une solution électriquement équivalente à la solution de la figure 1.

Les deux figures diffèrent essentiellement en ce que le courant à mesurer I traverse non seulement l'enroulement primaire d'un transformateur $T_r$ du type précité, mais également l'enroulement primaire du transformateur $T_{r1}$, les deux enroulements primaires étant connectés en série, de même que les enroulements secondaires correspondants.

**Revendications**

1. Appareil de mesure de courant, du type à couplage magnétique, comportant :
   - un transformateur (T) comprenant un circuit magnétique formé par un noyau (F) en matériau ferromagnétique avec un entrefer (E), un enroulement primaire (P) de (Np) spires disposé autour du noyau (F) et parcouru par le courant (I) à mesurer, et un enroulement secondaire (S) de ($N_s$) spires, disposé autour du noyau (F),
   - des moyens destinés à fournir à partir du flux magnétique induit par le courant (I) dans le noyau (F), un premier signal électrique ($v_r$, $v_{ad}$) proportionnel à la somme ($i_r$) des composantes alternatives à fréquences élevées du courant (I) à mesurer,
   - un dispositif (G) placé dans l'entrefer (E) du noyau (F) et destiné à fournir, à partir du flux magnétique induit par le courant (I) dans le noyau (F) et traversant l'entrefer (E), un second signal ($v_i$) électrique proportionnel à la somme ($I_m$) des composantes continue et alternatives à basses fréquences du courant (I) à mesurer,
   - et un moyen de sommation (Σ) desdits premier et second signaux pour fournir un troisième signal proportionnel au courant (I) à mesurer.

2. Appareil selon la Revendication 1, caractérisé en ce que lesdits moyens pour fournir ledit premier signal sont constitués par l'enroulement secondaire (S) qui est sensiblement court-circuité par une impédance de très faible valeur, ledit premier signal ($v_r$) étant prélevé aux bornes de l'impédance.

3. Appareil selon la Revendication 2, caractérisé en ce que l'impédance est une résistance pure.

4. Appareil selon la Revendication 1, caractérisé en ce que lesdits moyens pour fournir ledit premier signal sont constitués par un amplificateur ($A_{I/V}$), qui est alimenté par ledit enroulement secondaire (S) et dont l'entrée et la sortie présentent une borne commune, ledit premier signal étant défini par la tension existant entre les bornes d'une impédance d'accès à la sortie de l'amplificateur équivalente à l'admittance (Yμ) de la liaison entre entrée et sortie dudit amplificateur.

5. Appareil selon l'une quelconque des Revendications 1 ou 2, caractérisé en ce que lesdits moyens pour fournir ledit premier signal sont constitués par un troisième enroulement ($R_{ad}$) disposé autour dudit circuit magnétique (F), ledit premier signal étant défini par la tension existant entre les bornes dudit troisième enroulement, et en ce que ledit troisième enroulement comporte un nombre de spires (Nad) très élevé.

6. Appareil selon la Revendication 5, caractérisé en ce que ledit enroulement secondaire (S) présente une impédance constituée par la résistance propre de cet enroulement.

7. Appareil selon l'une quelconque des Revendications 1 à 6, caractérisé en ce que ledit enroulement primaire (P) dudit transformateur (Tr) est monté en série avec un enroulement primaire d'un second transformateur (Tr1), dont l'enroulement secondaire est monté en série avec l'enroulement secondaire (S) du premier transformateur (Tr).

8. Appareil selon l'une quelconque des Revendications 1 à 7, caractérisé en ce que le noyau (F) du circuit magnétique est réalisé en fer doux non laminé.

**Claims**

1. Current measuring instrument, of the magnetic coupling type, consisting of:
   - a transformer (T) comprising a magnetic circuit formed by a core (F) made of ferromagnetic material with an air gap (E), a primary winding (P) of (Np) turns which is arranged around the core (F) and through which the current to be measured passes, and a secondary winding (S) of ($N_s$) turns, arranged around the core (F),
   - means designed to provide, as a result of the magnetic flux induced by the current (I) in the core (F), a first electrical signal ($v_r$, $v_{ad}$) proportional to the sum ($i_r$) of the alternating components at high frequencies of the current (I) to be measured,
   - a device (G) placed in the air gap (E) of the core (F) and designed to provide, as a result of the magnetic flux induced by the current (I) in the core (F) and passing through the air gap (E), a

second electrical signal $(V_i)$ proportional to the sum $(I_m)$ of the continuous and alternating components at low frequencies of the current (I) to be measured,
- and a means of summation $(\Sigma)$ of the said first and second signals to provide a third signal proportional to the current (I) to be measured.

2. An instrument according to Claim 1, characterized in that the said means of providing the said first signal consist of the secondary winding (S) which is substantially short-circuited by an impedance of very low value, the said first signal $(v_r)$ being taken off at the terminals of the impedance.

3. An instrument according to Claim 2, characterized in that the impedance is a pure resistance.

4. An instrument according to Claim 1, characterized in that the said means of providing the said first signal consist of an amplifier $(A_{I/V})$ which is supplied by the said secondary winding (S) and whose input and output have a common terminal, the said first signal being defined by the voltage present between the terminals of a terminal impedance at the output of the amplifier equivalent to the admittance $(Y\mu)$ of the link between the input and the output of the said amplifier.

5. An instrument according to either of Claims 1 and 2, characterized in that the said means of providing the said first signal consist of a third winding $(R_{ad})$ arranged around the said magnetic circuit (F), the said first signal being defined by the voltage present between the terminals of the said third winding, and in that the said third winding comprises a very large number $(N_{ad})$ of turns.

6. An instrument according to Claim 5, characterized in that the said secondary winding (S) has an impedance constituted by the intrinsic resistance of this winding.

7. An instrument according to any of Claims 1 to 6, characterized in that the said primary winding (P) of the said transformer (Tr) is connected in series with a primary winding of a second transformer (Tr1) whose secondary winding is connected in series with the secondary winding (S) of the first transformer (Tr).

8. An instrument according to any of Claims 1 to 7, characterized in that the core (F) of the magnetic circuit is made of non-laminated soft iron.

**Patentansprüche**

1. Strommeßgerät mit magnetischer Kopplung,
   - mit einem Transformator (T) mit einem magnetischen Kreis, der von einem Kern (F) aus ferromagnetischen Material mit einem Luftspalt (E) gebildet wird, mit einer primäre Wicklung (P) mit $(N_p)$-Windungen, die um den Kern (F) herum angeordnet ist und von dem zu messenden Strom (I) durchflossen wird, und mit einer sekundären Wicklung (S) mit $(N_s)$-Windungen, die um den Kern (F) herum angeordnet ist,
   - mit Mitteln, mit denen aufgrund des magnetischen Flusses, der durch den Strom (I) in dem Kern (F) erzeugt wird, ein erstes elektrisches Signal $(v_r, v_{ad})$ erzeugbar ist, das zur Summe $(i_r)$ der Wechselstromanteile hoher Frequenz da zu messenden Stromes (I) proportional ist,
   - mit einer Vorrichtung (G), die in dem Luftspalt (E) des Kerns (F) angeordnet und dazu vorgesehen ist, aufgrund des durch den Strom (I) in dem Kern (F) induzierten und durch den Luftspalt (E) hindurchtretenden magnetischen Flusses ein zweites elektrisches Signal $(v_i)$ zu liefern, das proportional zur Summe $(I_m)$ der Gleichstromanteile und der Wechselstromanteile niedriger Frequenz des zu messenden Strom (I) ist, und
   - mit einem Summationsmittel $(\Sigma)$ für die besagten ersten und zweiten Signale, um ein drittes Signal zu erzeugen, welches proportional zu dem zu messenden Strom (I) ist.

2. Vorrichtung nach Anspruch 1, dadurch gekennzeichnet, daß die besagten Mittel zum Erzeugen des besagten ersten Signals aus einer sekundären Wicklung (S) bestehen, die durch eine Impedanz eines sehr geringen Wertes im wesentlichen kurzgescholssen ist, wobei das erste Signal $(v_r)$ an den Anschlüssen der Impedanz abgenommen wird.

**3.** Vorrichtung nach Anspruch 2, dadurch gekennzeichnet, daß die Impedanz aus einem reinen Widerstand besteht.

**4.** Vorrichtung nach Anspruch 1, dadurch gekennzeichnet, daß die besagten Mittel zur Erzeugung des ersten Signals aus einem Verstärker ($A_{I/V}$) bestehen, der von der sekundären Wicklung (S) gespeist wird und dessen Eingang und Ausgang einen gemeinsamen Anschluß aufweisen, wobei das erste Signal durch die Spannung definiert wird, die zwischen den Anschlüssen eines Eingangswiderstandes zum Ausgang des Verstärkers besteht, die zu der Admittanz ($Y_\mu$) der Verbindung zwischen Eingang und Ausgang da Verstärkers äquivalent ist.

**5.** Vorrichtung nach Anspruch 1 oder Anspruch 2, dadurch gekennzeichnet, daß die besagten Mittel zur Erzeugung des ersten Signale aus einer dritten Wicklung ($R_{ad}$) bestehen, die um den besagten magnetischen Kreis (F) herum angeordnet ist, wobei das erste Signal durch die Spannung definiert wird, die zwischen den Anschlüssen der dritten Wicklung besteht, und daß diese dritte Wicklung eine sehr hohe Windungsanzahl ($N_{ad}$) aufweist.

**6.** Vorrichtung nach Anspruch 5, dadurch gekennzeichnet, daß diese sekundäre Wicklung (S) eine Impedanz aufweist, die durch den Eigenwidersand dieser Wicklung vorgegeben ist.

**7.** Vorrichtung nach einem der Ansprüche 1 bis 6, dadurch gekennzeichnet, daß die primäre Wicklung (P) des Transformators ($T_r$) in Serie mit einer ersten Wicklung eines zweiten Transformators ($T_{rl}$) angeordnet ist, dessen sekundäre Wicklung in Serie mit der sekundären Wicklung (S) des ersten Transformators ($T_r$) angeordnet ist.

**8.** Vorrichtung nach einem der Ansprüche 1 bis 7, dadurch gekennzeichnet, daß der Kern (F) des magnetischen Kreises aus nicht-laminierten Weicheisen besteht.

# FIG.1

# FIG.2

FIG.2A

# FIG.3

# FIG.4

# FIG.5

## FIG.6

# FIG.7